# EUROPÄISCHE PATENTSCHRIFT

(11) **EP 3 138 125 B1**
(45) Veröffentlichungstag und Bekanntmachung des Hinweises auf die Patenterteilung: **26.08.2020**
(21) Anmeldenummer: 15718861.6
(22) Anmeldetag: 23.04.2015
(51) Int. Cl.: H01L 23/44, H01L 23/473, H01L 23/495, H01L 23/31, H05K 7/20, H01L 25/07

(54) **SCHALTUNGSANORDNUNG, STROMWANDLER MIT EINER SCHALTUNGSANORDNUNG**
CIRCUIT ARRANGEMENT, AND CURRENT TRANSFORMER HAVING A CIRCUIT ARRANGEMENT
MONTAGE DE CIRCUIT ET TRANSFORMATEUR DE COURANT ÉQUIPÉ D'UN MONTAGE DE CIRCUIT

(30) Priorität: 30.04.2014 DE 102014208255
(43) Veröffentlichungstag der Anmeldung: 08.03.2017
(73) Patentinhaber: Vitesco Technologies Germany GmbH, 30165 Hannover (DE)
(72) Erfinder: POLA, Olivier, 31500 Toulouse (DE)
(74) Vertreter: Waldmann, Georg Alexander
(86) Internationale Anmeldenummer: PCT/EP2015/058819
(87) Internationale Veröffentlichungsnummer: WO 2015/165800

(56) Entgegenhaltungen:
- EP-A1- 2 685 494
- DE-A1-102004 011 808
- JP-A- 2004 363 337
- JP-A- 2005 057 130
- JP-A- 2005 057 212
- JP-A- 2006 339 239
- JP-A- 2009 283 766

## Beschreibung

Die vorliegende Erfindung betrifft eine Schaltungsanordnung sowie einen Stromwandler umfassend eine genannte Schaltungsanordnung.

JP 2004 363337 A (TOYOTA MOTOR CORP) 24. Dezember 2004 (2004-12-24)beschreibt eine Kühlstruktur für eine Halbleitervorrichtung.

Schaltungsanordnungen mit Leistungsbauelementen, insbesondere Leistungselektronik zum Bereitstellen von Phasenströmen für einen Elektromotor, weisen hohe Verlustleistungen auf, die beim Betrieb der Schaltungsanordnungen entstehen. In Form von Abwärme führen die Verlustleistungen zur Temperaturerhöhung und zu Leistungseinbrüchen bei den Leistungsbauelementen bzw. den Schaltungsanordnungen, in extremen Fällen sogar zu Ausfällen der Leistungsbauelemente bzw. der Schaltungsanordnungen.

Daher muss die Abwärme zeitnah zu deren Entstehung von den Leistungsbauelementen bzw. den Schaltungsanordnungen abgeführt werden.

Die Aufgabe der vorliegenden Erfindung besteht somit darin, eine kostengünstige Möglichkeit bereitzustellen, die Abwärme von den Leistungsbauelementen bzw. den Schaltungsanordnungen effizient abzuführen.

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird eine Schaltungsanordnung bereitgestellt. Die Schaltungsanordnung umfasst ein Trägerteil, (zumindest) ein Leistungsbauelement sowie einen Kühlkanal zum Durchleiten eines Kühlmittels. Ferner umfasst die Schaltungsanordnung (zumindest) eine Stromschiene zum Leiten von elektrischen Strom zu dem Leistungsbauelement. Dabei ist die Stromschiene auf dem Trägerteil angeordnet und bildet einen Teil von Leiterbahnen aus. Die Stromschiene weist einen Bereich auf, der mit einer ersten Oberfläche und einer zweiten, der ersten Oberfläche entgegengesetzt liegenden Oberfläche von dem Trägerteil weg in den Kühlkanal ragt. Auf der ersten Oberfläche des Bereichs ist das Leistungsbauelement von dem durch den Kühlkanal fließenden Kühlmittel beströmbar angeordnet und mit dem Bereich elektrisch leitend und mechanisch verbunden.

Vorzugsweise ist das Trägerteil als ein Teil des Gehäuses der Schaltungsanordnung, insbesondere als ein Gehäusedeckel des Gehäuses, ausgebildet sein. In diesem Fall entfällt ein Schaltungsträger, der sonst als Träger der Stromschienen und der Leistungsbauelemente erforderlich ist.

Alternativ kann das Trägerteil aber auch als ein Schaltungsträger, insbesondere ein Keramiksubstrat, ausgebildet sein.

Der Erfindung liegt der Gedanke zugrunde, dass je kürzer der Wärmeübertragungsweg von der Wärmequelle, nämlich den Leistungsbauelementen, zu der Wärmesenke, z. B. dem Kühlmittel, ist, desto effizienter die Kühlung der Schaltungsanordnung ist.

Beim Anstreben, diesen Wärmeübertragungsweg auf technisch realisierbares Minimum zu reduzieren, wurde im Rahmen dieser Erfindung erkannt, dass die beste Lösung hierfür wäre, die Leistungsbauelemente direkt in das Kühlmittel einzutauchen.

Dabei wurde gestrebt, die mechanische Verbindung zwischen den Leistungsbauelementen und dem Trägerteil und die elektrischen Verbindungen von dem Trägerteil zu den Leistungsbauelementen weiterhin aufrechtzuerhalten.

So wurde eine Stromschiene entwickelt, die mit einem Bereich mit dem Trägerteil mechanisch und elektrisch leitend verbunden ist und mit einem weiteren Bereich von dem Trägerteil weg in den Kühlkanal hineinragt. Dabei ragt der Bereich mit einer ersten Oberfläche und einer zweiten, der ersten Oberfläche entgegengesetzt liegenden Oberfläche in den Kühlkanal, sodass die beiden voneinander angewandten Oberflächen von dem durch den Kühlkanal hindurchfließenden Kühlmittel bestromt werden können. Auf der ersten Oberfläche ist das Leistungsbauelement angeordnet und mit dem Bereich mechanisch und elektrisch leitend verbunden. Da die erste Oberfläche in den Kühlkanal hineinragt, kann auch das Leistungsbauelement direkt von dem durch den Kühlkanal hindurchfließenden Kühlmittel bestromt werden. Dadurch die Abwärme, die in dem Leistungsbauelement erzeugt wird, von dem Leistungsbauelement ohne Umweg direkt an das Kühlmittel abgegeben. Mit dieser Lösung wird nahezu die gleiche Wirkung erzielt, die mit Eintauchen des Leistungsbauelements direkt in das Kühlmittel erzielt werden kann.

Da die Stromschiene sowieso als Teil der Leiterbahnen für Leistungsbauelemente verwendet werden, kann die oben genannte Lösung ohne zusätzliche Komponenten kostengünstig erzielt werden.

Dadurch ist eine kostengünstige Möglichkeit bereitgestellt, mit der die Abwärme von den Leistungsbauelementen bzw. den Schaltungsanordnungen effizient abgeführt werden kann.

Gemäß einer bevorzugten Ausgestaltung ragt der Bereich der Stromschiene von dem Trägerteil mit einer Neigung zur Oberfläche des Trägerteils weg. Insbesondere ragt der Bereich senkrecht zur Oberfläche des Trägerteils vom Trägerteil weg.

Dabei kann ein Neigungswinkel des Bereichs zur Oberfläche des Trägerteils je nach Ausführung der Schaltungsanordnung bzw. des Trägerteils beliebig eingestellt werden. Wichtig ist nur, dass die Leistungsbauelemente an diesem Bereich zumindest größtenteils, vorzugsweise vollständig von dem Kühlmittel bestromt werden können.

Gemäß noch einer weiteren bevorzugten Ausgestaltung sind die Stromschiene, das Leistungsbauelement und/oder die Oberfläche des Trägerteils, die dem Kühlkanal zugewandt liegt und auf der die Stromschiene angeordnet ist, mit einer elektrisch isolierenden und wärmeleitenden Isolierschicht von dem Kühlkanal elektrisch isoliert.

Diese Isolationsschicht verhindert somit elektrische Kurzschlüsse in den Leistungsbauelementen und in der Schaltung auf dem Trägerteil durch das Kühlmittel.

Vorzugsweise weist diese Isolierschicht eine Schichtdicke von über 50 Mikrometer, insbesondere über 100 Mikrometer, speziell bis 300 Mikrometer, auf. Dabei enthält die Isolierschicht vorzugsweise ein Duroplast, ein Thermoplast, insbesondere ein umgegossener Kunststoff, und/oder Lack.

Duroplast, Thermoplast und Lack sind in verschiedener Ausführung als Massenware kostengünstig erhältlich.

Gemäß einem weiteren Aspekt der Erfindung wird ein Stromwandler, insbesondere ein Umrichter oder ein Inverter, bereitgestellt, der eine zuvor beschriebene Schaltungsanordnung umfasst.

Vorteilhafte Ausgestaltungen der zuvor beschriebenen Schaltungsanordnung sind, soweit im Übrigen auf den zuvor genannten Stromwandler übertragbar, auch als vorteilhafte Ausgestaltungen des Stromwandlers anzusehen.

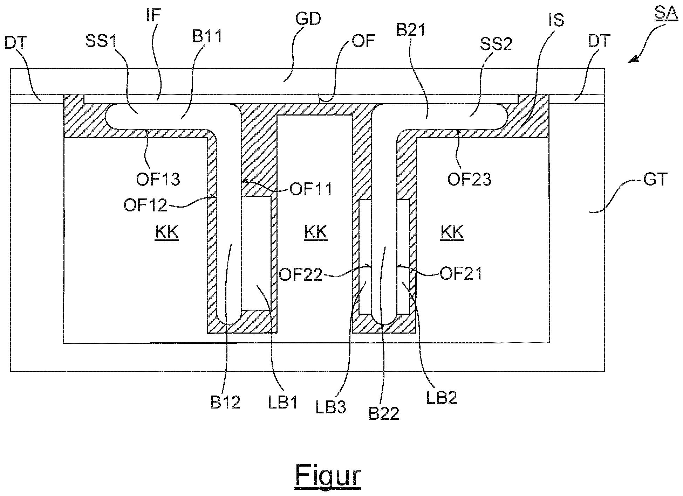

Im Folgenden wird eine beispielhafte Ausführungsform der Erfindung bezugnehmend auf eine Figur näher erläutert. Dabei zeigt die einzige Figur eine Schaltungsanordnung SA eines Stromwandlers in einer schematischen Querschnittdarstellung.

Die Schaltungsanordnung umfasst ein Gehäuseteil GT, das wannenförmig ausgebildet ist und einen Hohlraum umfasst. Der Hohlraum bildet einen Kühlkanal KK zum Durchleiten eines Kühlmittels aus.

Die Schaltungsanordnung SA umfasst ferner einen Gehäusedeckel GD, der auf dem Gehäuseteil GT angeordnet ist und den Hohlraum einseitig abschließt. Sowohl das Gehäuseteil GT als auch der Gehäusedeckel GD bestehen überwiegend aus einer Aluminiumlegierung oder Kupferlegierung. Zwischen dem Gehäuseteil GT und dem Gehäusedeckel GD ist eine Dichtverbindung DT in Form von bspw. einem formangepassten Dichtring angeordnet, die den Hohlraum und somit den Kühlkanal KK fluiddicht abdichtet.

Auf einer dem Kühlkanal KK zugewandten Oberfläche OF weist der Gehäusedeckel GD eine erste und eine zweite Stromschiene SS1, SS2 auf. Dabei sind die Stromschienen SS1, SS2 mittels einer elektrisch isolierenden Isolierklebefolie IF an dem Gehäusedeckel GD befestigt und zugleich von dem Gehäusedeckel GD elektrisch isoliert. Diese Stromschienen SS1, SS2 sind direkt oder mittels in der Figur nicht dargestellten elektrischen Verbindungen indirekt mit ebenfalls in der Figur nicht dargestellten Schaltungskomponenten elektrisch verbunden, die sich außerhalb des Hohlraumes befinden. Die beiden Stromschienen SS1, SS2 dienen zur Übertragung von elektrischen Strömen.

Die erste Stromschiene SS1 umfasst einen ersten Bereich B11 und einen zweiten Bereich B12, wobei die beiden Bereiche B11, B12 zueinander L-förmig gebogen sind.

Mit dem ersten Bereich B11 ist die erste Stromschiene SS1 mit der Isolierklebefolie IF bzw. mit dem Gehäusedeckel GD mechanisch verbunden.

Der zweite Bereich B12 ragt senkrecht zu der Oberfläche OF des Gehäusedeckels GD von dem Gehäusedeckel GD weg und somit in den Kühlkanal KK hinein. Der zweite Bereich B12 weist eine erste Oberfläche OF11 und eine zweite, der ersten Oberfläche OF11 entgegengesetzt liegende Oberfläche OF12 auf. Auf der ersten Oberfläche OF11 ist ein Leistungsbauelement LB1 angeordnet, das über eine in der Figur nicht dargestellte Lötverbindung mit der ersten Stromschiene SS1 mechanisch und elektrisch leitend verbunden ist.

Beim Betrieb der Schaltungsanordnung SA leitet die Stromschiene SS1 einen Strom zu dem Leistungsbauelement LB1, der von einer weiteren in der Figur nicht dargestellten Stromschiene wieder von dem Leistungsbauelement LB1 abgeführt wird. Dabei ist das Leistungsbauelement LB1 beispielsweise als ein Leistungskondensator ausgebildet.

Die zweite Stromschiene SS2 umfasst analog einen ersten Bereich B21 und einen zweiten Bereich B22, wobei die beiden Bereiche B21, B22 ebenfalls zueinander L-förmig gebogen sind.

Über den ersten Bereich B21 ist die zweite Stromschiene SS2 mit der Isolierklebefolie IF bzw. mit dem Gehäusedeckel GD mechanisch verbunden.

Der zweite Bereich B22 ragt senkrecht zu der Oberfläche OF des Gehäusedeckels GD von dem Gehäusedeckels GD weg und somit ebenfalls in den Kühlkanal KK hinein. Der zweite Bereich B22 weist eine erste Oberfläche OF21 und eine zweite, der ersten Oberfläche OF21 entgegengesetzt liegende Oberfläche OF22 auf. Auf der ersten Oberfläche OF21 des zweiten Bereichs B12 ist ein weiteres Leistungsbauelement LB2 angeordnet, das über eine in der Figur nicht dargestellte Lötverbindung mit der zweiten Stromschiene SS2 mechanisch und elektrisch leitend verbunden ist. Auf der zweiten Oberfläche OF22 des zweiten Bereichs B12 ist noch ein weiteres Leistungsbauelement LB3 angeordnet, das ebenfalls über eine in der Figur nicht dargestellte Lötverbindung mit der zweiten Stromschiene SS2 mechanisch und elektrisch leitend verbunden ist.

Beim Betrieb der Schaltungsanordnung SA leitet die Stromschiene SS1 einen Strom zu den beiden Leistungsbauelementen LB2, LB3, der wiederum von weiteren, in der Figur nicht dargestellten Stromschienen von den beiden Leistungsbauelementen LB2, LB3 abgeführt wird. Dabei sind die beiden Leistungsbauelemente LB2, LB3 jeweils als ein Leistungstransistor und eine Leistungsdiode ausgebildet.

Die Schaltungsanordnung SA umfasst ferner eine Isolationsschicht IS, die die Oberflächen OF11, OF12, OF21, OF22 der jeweiligen zweiten Bereiche B12, B22 der beiden Stromschienen SS1, SS2, Oberflächen 013, OF23 der jeweiligen ersten Bereiche B11, B21 der beiden Stromschienen SS1, SS2, die von dem Gehäusedeckel GD abgewandt liegen, freiliegende Oberflächen der Leistungsbauelemente LB1, LB2, LB3, die sich an den Kühlkanal KK angrenzen, sowie die Oberfläche OF des Gehäusedeckels GD bedeckt und dabei die beiden Stromschienen SS1, SS2, die drei Leistungsbauelementen LB1, LB2, LB3 sowie den Gehäusedeckel GD von dem Kühlkanal KK elektrisch isoliert. Dabei besteht die Isolationsschicht IS aus einem Duroplast und weist eine Schichtdicke von 50 bis 150 Mikrometer auf.

Beim Betrieb der Schaltungsanordnung SA entsteht Abwärme in den drei Leistungsbauelementen LB1, LB2, LB3 infolge der Verlustleistungen in den Leistungsbauelementen LB1, LB2, LB3. Diese Abwärme wird von der Isolationsschicht IS aufgenommen und an das durch den Kühlkanal KK fließende Kühlmittel abgegeben. Durch den kurzen Wärmeübertragungsweg von den Leistungsbauelementen LB1, LB2, LB3 zu dem Kühlmittel kann die Abwärme effizient abgeführt werden.

Die beiden Stromschienen SS1, SS2 können zur einfachen Handhabung in einer anschließenden Montagephase an dem Gehäusedeckel GD im Vorfeld über einen Kunststoffträger miteinander mechanisch verbunden werden. Hierzu werden die beiden Stromschienen SS1, SS2 an jeweiligen Bereichen, deren Oberflächen nicht zur elektrischen Verbindung mit den Leistungsbauelementen LB1, LB2, LB3 oder zur mechanischen Befestigung an dem Gehäusedeckel GD vorgesehen sind, mit einer Kunststoffmaße umgossen, die nach dem Erhärten den Kunststoffträger ausbilden, der die beiden Stromschienen SS1, SS2 miteinander mechanisch verbindet und zugleich voneinander elektrisch isoliert.

Je nach Ausführung können auch weitere Stromschienen vorgesehen sein, die zueinander zugewandt angeordnet und miteinander über eine Isolierfolie mechanisch verbunden sind, die die Stromschienen voneinander elektrisch isoliert.

Zwischen den Leistungsbauelementen LB1, LB2, LB3 können zudem auch weitere Stromschienen vorgesehen sein, die die Leistungsbauelementen LB1, LB2, LB3 miteinander elektrisch verbinden. Solche Stromschienen sind dann wie die Leistungsbauelemente LB1, LB2, LB3 vollständig in dem Kühlkanal KK eingetaucht und werden von dem Kühlmittel umströmt. Dabei werden diese Stromschienen wie die jeweiligen zweiten Bereiche B12, B22 der beiden zuvor beschriebenen Stromschienen SS1, SS2, die in den Kühlkanal KK hineinragen, von der Isolationsschicht IS ummantelt und somit von dem Kühlmittel elektrisch isoliert.

## Patentansprüche

1. Schaltungsanordnung (SA), umfassend:
- ein Trägerteil (GD),
- ein Leistungsbauelement (LB1, LB2, LB3),
- einen Kühlkanal (KK) zum Durchleiten eines Kühlmittels,
- eine Stromschiene (SS1, SS2) zum Leiten eines Stromes zu dem Leistungsbauelement (LB1, LB2, LB3), die auf dem Trägerteil (GD) angeordnet ist und einen Bereich (B12, B22) aufweist, der mit einer ersten Oberfläche (OF11, OF21) und einer zweiten, der ersten Oberfläche (OF11, OF21) entgegengesetzten Oberfläche (OF12, OF22) von dem Trägerteil (GD) weg in den Kühlkanal (KK) ragt,
- wobei das Leistungsbauelement (LB1, LB2, LB3) auf der ersten Oberfläche (OF11, OF21) des Bereichs (B12, B22) angeordnet und mit dem Bereich (B12, B22) elektrisch leitend und mechanisch verbunden ist,
**dadurch gekennzeichnet, dass**
- die Stromschiene (SS1, SS2) auf einer dem Kühlkanal (KK) zugewandten Oberfläche (OF) des Trägerteils (GD) angeordnet ist und ferner einen weiteren Bereich (B11, B21) aufweist, über den die Stromschiene (SS1, SS2) an der dem Kühlkanal (KK) zugewandten Oberfläche (OF) des Trägerteils (GD) mechanisch befestigt ist,
- wobei die beiden Bereiche (B11, B12; B21, B22) zueinander L-förmig gebogen sind.

2. Schaltungsanordnung (SA) nach Anspruch 1, wobei der Bereich (B12, B22) von dem Trägerteil (GD) mit einer Neigung, insbesondere senkrecht, zur Oberfläche (OF) des Trägerteils (GD) weg ragt.

3. Schaltungsanordnung (SA) nach Anspruch 1 oder 2, wobei die Stromschiene (SS1, SS2), das Leistungsbauelement (LB1, LB2, LB3) und/oder die Oberfläche (OF) des Trägerteils (GD) mit einer elektrisch isolierenden und wärmeleitenden Isolierschicht (IS) von dem Kühlkanal (KK) isoliert sind.

4. Schaltungsanordnung (SA) nach Anspruch 3, wobei die Isolierschicht (IS) eine Schichtdicke von über 50 Mikrometer, insbesondere über 100 Mikrometer, speziell bis 300 Mikrometer, aufweist.

5. Schaltungsanordnung (SA) nach Anspruch 3 oder 4, wobei die Isolierschicht (IS) ein Duroplast, ein Thermoplast, insbesondere ein umgegossener Kunststoff, und/oder Lack enthält.

6. Stromwandler umfassend eine Schaltungsanordnung (SA) nach einem der vorangehenden Ansprüche.

## Claims

1. Circuit arrangement (SA) comprising:
- a carrier part (GD),
- a power component (LB1, LB2, LB3),
- a cooling channel (KK) for conveying a cooling agent,
- a busbar (SS1, SS2) for conducting a current to the power component (LB1, LB2, LB3), which busbar is arranged on the carrier part (GD) and has a region (B12, B22) which, with a first surface (OF11, OF21) and a second surface (OF12, OF22) opposite the first surface (OF11, OF21), projects away from the carrier part (GD) into the cooling channel (KK),
- wherein the power component (LB1, LB2, LB3) is arranged on the first surface (OF11, OF21) of the region (B12, B22) and is connected to the region (B12, B22) in an electrically conductive and mechanical manner,
**characterized in that**
- the busbar (SS1, SS2) is arranged on a surface (OF) of the carrier part (GD) facing the cooling channel (KK) and also has a further region (B11, B21), via which the busbar (SS1, SS2) is mechanically fastened on that surface (OF) of the carrier part (GD) which faces the cooling channel (KK),
- wherein the two regions (B11, B12; B21, B22) are bent in an L-shaped manner with respect to one another.

2. Circuit arrangement (SA) according to Claim 1, wherein the region (B12, B22) projects away from the carrier part (GD) at an angle, in particular perpendicularly, to the surface (OF) of the carrier part (GD).

3. Circuit arrangement (SA) according to Claim 1 or 2, wherein the busbar (SS1, SS2), the power component (LB1, LB2, LB3) and/or the surface (OF) of the carrier part (GD) is/are insulated from the cooling channel (KK) by an electrically insulating and thermally conductive insulating layer (IS).

4. Circuit arrangement (SA) according to Claim 3, wherein the insulating layer (IS) has a layer thickness exceeding 50 micrometres, in particular exceeding 100 micrometres, especially up to 300 micrometres.

5. Circuit arrangement (SA) according to Claim 3 or 4, wherein the insulating layer (IS) contains a thermoset plastic, a thermoplastic, in particular a cast plastic, and/or a lacquer.

6. Current converter comprising a circuit arrangement (SA) according to one of the preceding claims.

## Revendications

1. Arrangement de circuit (SA) comprenant :
- une partie porteuse (GD),
- un composant de puissance (LB1, LB2, LB3),
- un canal de refroidissement (KK) destiné à conduire un fluide de refroidissement,
- une barre-bus (SS1, SS2) destinée à conduire un courant vers le composant de puissance (LB1, LB2, LB3), laquelle est disposée sur la partie porteuse (GD) et possède une zone (B12, B22) qui fait saillie dans le canal de refroidissement (KK) en s'écartant de la partie porteuse (GD) par une première surface (OF11, OF21) et une deuxième surface (OF12, OF22) à l'opposé de la première surface (OF11, OF21),
- le composant de puissance (LB1, LB2, LB3) étant disposé sur la première surface (OF11, OF21) de la zone (B12, B22) et étant relié de manière électriquement conductrice et mécaniquement à la zone (B12, B22),
**caractérisé en ce que**
- la barre-bus (SS1, SS2) est disposée sur une surface (OF) de la partie porteuse (GD) qui fait face au canal de refroidissement (KK) et possède en outre une zone supplémentaire (B11, B21) par le biais de laquelle la barre-bus (SS1, SS2) est fixée mécaniquement à la surface (OF) de la partie porteuse (GD) qui fait face au canal de refroidissement (KK),
- les deux zones (B11, B12 ; B21, B22) étant coudées l'une par rapport à l'autre en forme de L.

2. Arrangement de circuit (SA) selon la revendication 1, la zone (B12, B22) faisant saillie à l'écart de la partie porteuse (GD) avec une inclinaison, notamment perpendiculairement à la surface (OF) de la partie porteuse (GD).

3. Arrangement de circuit (SA) selon la revendication 1 ou 2, la barre-bus (SS1, SS2), le composant de puissance (LB1, LB2, LB3) et/ou la surface (OF) de la partie porteuse (GD) étant isolés du canal de refroidissement (KK) avec une couche isolante (IS) électriquement isolante et thermoconductrice.

4. Arrangement de circuit (SA) selon la revendication 3, la couche isolante (IS) possédant une épaisseur de couche de plus de 50 micromètres, notamment de plus de 100 micromètres, en particulier jusqu'à 300 micromètres.

5. Arrangement de circuit (SA) selon la revendication 3 ou 4, la couche isolante (IS) contenant un plastique thermodurci, un thermoplastique, notamment une matière plastique enrobée et/ou un vernis.

6. Convertisseur de courant comprenant un arrangement de circuit (SA) selon l'une des revendications précédentes.
